# EUROPÄISCHE PATENTSCHRIFT

(11) **EP 1 704 606 B1**
(45) Veröffentlichungstag und Bekanntmachung des Hinweises auf die Patenterteilung: **01.07.2009**
(21) Anmeldenummer: 05706676.3
(22) Anmeldetag: 13.01.2005
(51) Int. Cl.: H01L 51/00

(54) **Verfahren zur Herstellung eines organischen Transistors mit selbstjustierender Gate-Elektrode**
METHOD FOR THE PRODUCTION OF AN ORGANIC TRANSISTOR COMPRISING A SELF-ADJUSTING GATE ELECTRODE
PROCÉDÉ DE FABRICATION DE TRANSISTOR ORGANIQUE À ÉLECTRODE GRILLE AUTORÉGLABLE

(30) Priorität: 14.01.2004 DE 102004002024
(43) Veröffentlichungstag der Anmeldung: 27.09.2006
(73) Patentinhaber: PolyIC GmbH & Co. KG, 90763 Fürth (DE)
(72) Erfinder: FIX, Walter, 90427 Nürnberg (DE); FICKER, Jürgen, 91052 Erlangen (DE)
(74) Vertreter: Zinsinger, Norbert
(86) Internationale Anmeldenummer: PCT/DE2005/000039
(87) Internationale Veröffentlichungsnummer: WO 2005/069399

(56) Entgegenhaltungen:
- WO-A-02/065557
- US-A1- 2002 056 839
- US-A1- 2002 068 392
- D. P. GOSAIN: "Excimer laser crytallized poly-Si TFTs on plastic substrates" SECOND INTERNATIONAL SYMPOSIUM ON LASER PRECISION MICROFABRICATION 16-18 MAY 2001 SINGAPORE, Bd. 4426, 2002, Seiten 394-400, XP002327972 Proceedings of the SPIE - The International Society for Optical Engineering SPIE-Int. Soc. Opt. Eng USA ISSN: 0277-786X

## Beschreibung

Die vorliegende Erfindung betrifft einen organischen Transistor und ein Verfahren zum Herstellen des organischen Transistors. Insbesondere betrifft die vorliegende Erfindung einen organischen Transistor mit selbstjustierender Gate-Elektrode bzw. ein Verfahren zur Herstellung dieses organischen Transstors.

Transistoren sind die zentralen Bauelemente jeder elektronischen Schaltung, so dass im Allgemeinen der Aufwand und die Kosten für die Herstellung der Transistoren als auch die Eigenschaften der Transistoren in elektronischen Schaltungen weitgehend bestimmend für diese Schaltungen sind. Dies trifft ebenso für das Gebiet der organischen Schaltungen zu, die durch die Entwicklung von elektrisch leitfähigen und elektrisch halbleitenden Materialien, insbesondere Polymere, ermöglicht wurden. Organische Transistoren setzten sich in Analogie zu den klassischen Transistoren ebenfalls aus verschiedenen Schichten einschließlich Isolatorschicht, Halbleiterschicht sowie Source-, Drain- und Gate-Elektroden-Schichten zusammen.

Derzeit werden für die Herstellung von organischen Bauelementen und insbesondere organischen Transistoren Druckverfahren bevorzugt, die wirtschaftlich vorteilhaft sind und die Produktion von Transistoren in wenigen Prozess-Schritten erlauben. Kennzeichnend für Druckverfahren vom Stand der Technik ist das sukzessive strukturierte Aufbringen bzw. Aufdrucken der funktionellen organischen Schichten.

Insbesondere bei dem Top-Gate-Aufbau von Transistoren, das heißt, wenn die Gate-Elektroden-Schicht zuletzt auf die Transistor-Struktur aufgebracht wird, ist eine Justage der Gate-Elektroden-Schicht gegenüber der Source- bzw. Drain-Elektroden-Schicht mit ausreichender Genauigkeit notwendig. Die Genauigkeit der Justage der Gate-Elektroden-Schicht bestimmt die Größe eines Überlappungsbereichs von Gate-Elektroden-Schicht und Source- bzw. Drain-Elektroden-Schicht. Dieser Überlappungsbereich, der typischerweise bei einigen 10 µm liegt nimmt entscheidend Einfluss auf die parasitären Kapazitäten der mit Hilfe der herkömmlichen organischen Transistoren aufgebauten integrierten Schaltungen. Derartige parasitäre Kapazitäten sind vor allem bei Steigerung der Frequenz der Schaltungen nachteilig und bestimmen unter anderem eine obere Grenzfrequenz für den Betrieb von Schaltungen fest. Somit definieren die parasitären Kapazitäten der Transistoren maßgeblich die Leistungsfähigkeit und Qualität von Schaltungen. Die Unterschreitung der bei herkömmlichen Produktionsmethoden typischen einigen 10 µm für den Überlappungsbereich ist bisher im Rahmen einer Serienproduktion wirtschaftlich nicht möglich.

Die Qualität und somit die Leistungsfähigkeit von organischen Transistoren wird ferner weiterhin durch die Homogenität der funktionellen Schichten bestimmt. Hierbei ist zu bemerken, dass der Begriff der Homogenität einer Schicht insbesondere eine konstante Dicke bzw. einen konstanten Dickenparameter einer Schicht umfasst. Bei der Auftragung einer Schicht, die auf einen unebenen Untergrund aufzutragen ist, zum Beispiel eine in mehrfachen Schritten gedruckte strukturierte Schicht, kann die Auftragung zwangsläufig in einer Schicht nicht optimaler Homogenität resultieren. Dies ist insbesondere bei dem alternativen Bottom-Gate-Aufbau von Transistoren, das heißt, die Gate-Elektroden-Schicht wird zuerst auf die Transistor-Struktur aufgebracht, zu berücksichtigen, wenn die Isolatorschicht auf eine strukturierte Gate-Elektroden-Schicht aufzubringen ist. Bei diesem Prozess-Schritten kann eine ausreichende Homogenität nicht gewährleistet werden.

Aus der WO 2002/065557) ist ein Verfahren bekannt, bei dem die Fotolithographie ohne Angreifen bzw. Anlösen der organischen Schichten in allen Arbeitsschritten eingesetzt wird. Darüber hinaus wird beschrieben, wie die Durchkontaktierung zwischen Leiterbahnen auf verschiedenen Ebenen in organischen integrierten Schaltungen in einfacher Weise ermöglicht werden kann.

Im Gegensatz dazu ist es eine Aufgabe der Erfindung, ein Verfahren zum Herstellen eines organischen Transistors bereitzustellen, die es ermöglicht, eine Source- bzw. Drain-Elektroden-Schicht derart zu bilden, dass eine Überlappung der Source- bzw. Drain-Elektroden-Schicht und einer Gate-Elektroden-Schicht vermieden wird, so dass parasitäre Effekte bedingt durch Source- bzw. Drain-Elektroden-Schicht und einer Gate-Elektroden-Schicht möglichst gering sind.

Eine weitere Aufgabe der Erfindung ist, die Homogenität der funktionellen Schichten des organischen Transistors zu gewährleisten.

Die Aufgabe der Erfindung wird durch ein Herstellungsverfahren gemäß Anspruch 1 bzw. durch einen organischen Transistor gemäß Anspruch 7 gelöst.

Gegenstand der vorliegenden Erfindung ist demnach ein Herstellungsverfahren für einen organischen Transistor. Für die Herstellung des erfindungsgemäßen organischen Transistors wird ein Substrat bereitgestellt, auf dem eine unstrukturierte Halbleiterschicht aufgebracht ist, auf der wiederum eine unstrukturierte Isolatorschicht angeordnet ist. Zumindest die Isolatorschicht wird strukturiert, so dass anschließend zumindest Source- und Drain-Elektroden-Schichten gebildet werden können.

Die unstrukturiert auf dem Substrat angeordneten Schichten sind besonders vorteilhaft, da diese Schichten problemlos homogen ausgebildet werden können. Eine die Homogenität der Schichten störende Strukturierung ist nicht vorhanden.

Vorteilhafte Ausgestaltungen der Erfindung ergeben sich aus den abhängigen Ansprüchen.

Erfindungsgemäß ist ferner eine unstrukturierte Gate-Elektroden-Schicht auf der Isolatorschicht des bereitgestellten Substrates angeordnet. Die Isolatorschicht und die Gate-Elektroden-Schicht werden gemeinsam strukturiert, um definierte Bereiche der vormals bedeckten Halbleiterschicht freizulegen. Anschließend werden die freiliegenden Bereiche der Halbleiterschicht dotiert, um diese dauerhaft leitfähig zu machen, so dass die dotierten Bereiche als Source- und Drain-Elektroden-Schichten dienen können. Das Dotieren der freiliegenden Bereiche der Halbleiterschicht kann mittels einer dotierenden Chemikalie erfolgen.

Erfindungsgemäß ist ferner eine unstrukturierte Gate-Elektroden-Schicht auf der Isolatorschicht angeordnet. Die Halbleiterschicht, die Isolatorschicht sowie die Gate-Elektroden-Schicht werden gemeinsam strukturiert, so dass definierte Bereiche des vormals durch die Schichten bedeckten Substrats freiliegen. Durch Aufbringen von einer elektrisch leitfähigen Substanz auf die freiliegenden Bereiche werden Source- und Drain-Elektroden-Schichten gebildet.

Erfindungsgemäß können ebenso die Halbleiterschicht sowie die Isolatorschicht strukturiert werden, so dass definierte Bereiche des vormals durch die Schichten bedeckten Substrats freiliegen. Anschließend werden sowohl die Source- und Drain-Elektroden-Schichten als auch Gate-Elektroden-Schicht durch Aufbringen einer elektrisch leitfähigen Substanz gebildet. Die leitfähige Substanz wird hierfür auf die freiliegenden Bereiche des Substrats sowie auf die Isolatorschicht aufgebracht.

Die Bildung der Source- und Drain-Elektroden-Schichten nach der Strukturierung zumindest der Isolatorschicht gewährleistet, dass eine Überlappung sowohl der Gate-Elektroden-Schicht als auch der Source- und Drain-Elektroden-Schichten im wesentlichen vermieden wird.

Die Strukturierung erfolgt vorzugsweise mittels eines Lasers, eines lithographischen Prozesses oder eines drucklithographischen Prozesses.

Das Substrat ist vorteilhafterweise ein organisches Substrat, bevorzugt eine Kunststofffolie und insbesondere eine Polyesteroder eine organische Folie. Die Halbleiterschicht basiert vorteilhafterweise auf einer organischen halbleitenden Substanz. Die Halbleiterschicht kann insbesondere aus einem der polymeren Substanzen wie zum Beispiel Polyalkylthiophen, Poly-Di-Hexyl-Ter-Thiophen (PDHTT) und Polyfluoren-Derivaten gebildet sein. Vorteilhafterweise ist die Isolatorschicht eine organischen elektrisch isolierenden Isolatorschicht.

Gemäß einem weiteren Aspekt der Erfindung wird ein organischer Transistor bereitgestellt. Der organische Transistor ist gemäß dem vorstehend beschriebenen Verfahrensherstellbar. Insbesondere zeichnet sich ein derartiger organischer Transistor dadurch aus, dass die Source- und Drain-Elektroden-Schichten und die Gate-Elektroden-Schicht sich im wesentlichen nicht überlappen.

Einzelheiten und bevorzugte Ausführungsformen des erfindungsgemäßen Gegenstands ergeben sich aus den abhängigen Ansprüchen sowie den Zeichnungen, anhand derer im folgenden Ausführungsbeispiele detailliert erläutert werden, so dass der erfindungsgemäße Gegenstand klar ersichtlich wird. In den Zeichnungen zeigen:
- Fig. 1a: eine Anordnung von unstrukturierten funktionellen Schichten eines typischen organischen Transistors;
- Fig. 1b: eine erste Strukturierung der funktionellen Schich- ten nicht gemäß der Erfin- dung;
- Fig. 1c: eine zweite Strukturierung der funktionellen schichten nicht gemäß der Er- findung;
- Fig. 2a: eine erste Strukturierung der funktionellen Schich- ten gemäß einer ersten Ausführungsform der Erfin- dung;
- Fig. 2b: eine zweite Strukturierung der funktionellen Schichten gemäß einer ersten Ausführungsform der Erfindung;
- Fig. 3a: eine erste Strukturierung der funktionellen Schich- ten gemäß einer weiteren Ausführungsform nicht gemäß der Erfindung; und
- Fig. 3b: eine zweite Strukturierung der funktionellen Schichten gemäß einer weiteren Ausführungsform nicht gemäß der Erfindung.

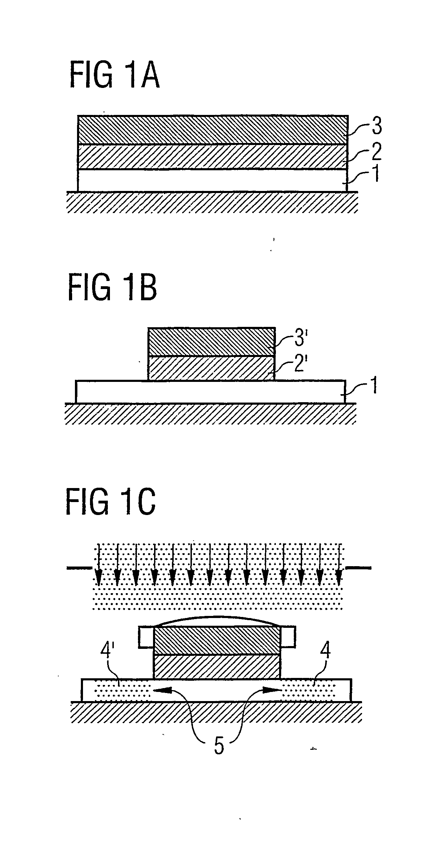

Eine Ausführungsform zur Herstellung eines nicht erfindungsgemäßen organischen Transistors ist beispielhaft in den Fig. 1a bis Fig. 1c illustriert.

Gemäß Fig. 1 wird auf einem Substrat in einem Herstellungsprozess eine homogene, unstrukturierte Halbleiterschicht 1 aufgebracht. Auf die Halbleiterschicht 1 wird im weiteren Verlauf eine unstrukturierte Isolatorschicht 2 und nachfolgend eine unstrukturierte Gate-Elektroden-Schicht 3 aufgebracht. Das großflächige unstrukturierte Aufbringen der funktionellen Schichten auf dem Substrat gewährleistet, dass die Schichten eine hohe Qualität aufweisen, d.h. insbesondere eine im wesentlichen optimale Homogenität und im wesentlichen eine konstante Dicke über der Auftragungsfläche.

Das Substrat, das als Träger zumindest für den organischen Transistor dient, ist bevorzugt aus flexiblem Material gebildet. Hierfür kommen zum Beispiel dünne Gläser als auch Kunststofffolien in Betracht. Aus dem Bereich der Kunststofffolien kommen ferner bevorzugt Polyethylenterephthalat-, Polyimid- und Polyesterfolien zum Einsatz. Die Dicke des Substrats ist im wesentlichen bestimmend für die Gesamtdicke des Bauelements, da die Schichtdicken der auf das Substrat aufgebrachten funktionellen Schichten um Größenordungen geringer sind. Eine typischerweise Substratdicke liegt im Bereich von 0,05 bis 0,5 mm.

Unter dem Begriff "organische Materialien" sollen alle Arten von organischen, metallorganischen und/oder anorganischen Kunststoffen unter Ausnahme der klassischen auf Germanium, Silizium usw. basierenden Halbleitermaterialien verstanden werden. Ferner soll der Begriff "organisches Material" ebenfalls nicht auf kohlenstoffhaltiges Material beschränkt sein, vielmehr sind ebenfalls Materialien wie Silicone möglich. Weiterhin sind neben polymeren und oligomeren Substanzen ebenso "small molecules" verwendbar.

So kann die funktionellen Halbleiterschichten 1 beispielsweise aus Polythiophenen, Polyalkylthiophen, Poly-Di-Hexyl-Ter-Thiophen (PDHTT), Polythienylenvinylenen, Polyfluoren-Derivaten oder konjugierten Polymeren bestehen, um eine Auswahl an möglichen Substanzen zu benennen. Die Halbleiterschicht 1 kann ebenso aus Lösung durch Aufschleudern (spincoating), Rakeln oder Bedrucken verarbeitet.

Die Gate-Elektroderr-Schicht kann aus verschiedensten Substanzen realisiert werden, d.h. je nach Wahl des Herstellungsprozesses und Anforderungen an die Gate-Elektroden-Schicht kommen organische als auch metallische Substanzen in Betracht.

Die in Fig. 1a dargestellten unstrukturierten auf dem Substrat aufgetragene Isolatorschicht 2 und Gate-Elektroden-Schicht 3 werden anschließend gemeinsam strukturiert. Die Strukturierung kann zum Beispiel mittels Abtragen durch einen Laser erfolgen oder alternativ mittels Schutzlack in lithographischen oder drucklithographischen Prozessen.

Fig. 1b zeigt die Ausbildung der funktionellen Schichten nach der vorstehend beschriebenen Strukturierung. Sowohl die Isolatorschicht 2' als auch die Gate-Elektroden-Schicht 3' liegen strukturiert vor, während die Halbleiterschicht 1 im wesentlichen von der Strukturierung unberührt verbleibt und freiliegende Bereiche aufweist, die nicht mehr von der strukturierten Isolatorschicht 2' bzw. der strukturierten Gate-Elektroden-Schicht 3' bedeckt sind.

Gemäß Fig. 1c werden anschließend an die gemeinsame Strukturierung der Isolatorschicht 2' und der Gate-Elektroden-Schicht 3' die Source- und Drain-Elektroden-Schichten 4, 4' ausgebildet. Die Bildung der Source- und Drain-Elektroden-Schichten 4, 4' wird durch Dotieren der durch die Strukturierung der Isolatorschicht 2' und der Gate-Elektroden-Schicht 3' freiliegenden Bereichen der Halbleiterschicht 1 erreicht. Die Dotierung kann zum Beispiel durch einen direkten Druckprozess erhalten werden, indem eine dotierende Chemikalie auf die freiliegenden Bereiche des Halbleiters 1 aufgebracht wird. Die dotierende Chemikalie wirkt hierbei auf den Halbleiter 1 ein und erzeugt eine dauerhaft Leitfähigkeit, so dass die dotierten Bereiche des Halbleiters 1 als Source- und Drain-Elektroden-Schichten 4, 4' zur Verfügung stehen. Alternativ kann der Druckprozess indirekt erfolgen, indem zuerst eine strukturierte Schutzschicht aufgedruckt wird, so dass das Einwirken der dotierenden Chemikalie auf Bereiche beschränkt wird, die nicht von einer Schutzschicht bedeckt sind.

In einer speziellen Ausführungsform der vorstehend beschriebenen Herstellung bzw. der vorstehend beschriebenen aus der Herstellung resultierenden Transistors ist das Substrat aus Polyesterfolie gebildet. Als Halbleiter-Material kommt insbesondere Polyalkylthiophen, vorzugsweise Pöly-Di-Hexyl-Ter-Thiophen (PDHTT) oder Polyfluoren-Derivate in Betracht, die aufgeschleudert oder aufgedruckt werden können. Ferner wird eine polymere Isolatorschicht und eine organische oder metallische Gate-Elektroden-Schicht eingesetzt. Mit einem Laser können die Gate-Elektroden-Schicht und die Isolatorschicht gemeinsam strukturiert werden. Anschließend werden die freiliegenden Bereiche der Halbleiterschicht mittels Eisenchlorid FeCl₃ in Acetonitril dotiert.

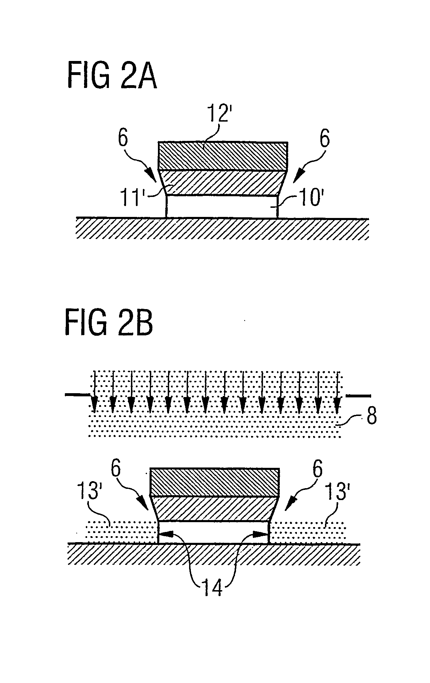

Eine erste Ausführungsform zur Herstellung eines erfindungsgemäßen organischen Transistors ist beispielhaft in den Fig. 2a und Fig. 2b illustriert.

Ausgangspunkt ist wie vorstehend in bezug auf Fig. 1a beschrieben, ein Substrat, auf das eine unstrukturierte, homogene Halbleiterschicht 1 aufgetragen ist, die von einer Isolatorschicht 2 bedeckt ist, die wiederum eine Gate-Elektroden-Schicht 3 trägt.

Die in Fig. 1a entsprechend dargestellten unstrukturierten auf dem Substrat aufgetragene Halbleiterschicht 1, Isolatorschicht 2 und Gate-Elektroden-Schicht 3 werden anschließend gemeinsam strukturiert. Die Strukturierung kann zum Beispiel mittels Abtragen durch einen Laser erfolgen oder alternativ mittels Schutzlack in lithographischen oder drucklithographischen Prozessen.

Fig. 2a zeigt die Ausbildung der funktionellen Schichten nach der vorstehend beschriebenen Strukturierung. Sowohl die Halbleiterschicht 10', die Isolatorschicht 11' als auch die Gate-Elektroden-Schicht 12' liegen strukturiert vor. Gemäß Fig. 2a kann die Isolatorschicht 11' unterätzte Strukturen 6 aufweisen, die geeignet sind, einem Kurzschluss zwischen Gate-Elektroden-Schicht 12' und zu erzeugenden Source- bzw. Drain-Elektroden-Schichten vorzubeugen. Als unterätzte Strukturen 6 soll eine Schicht verstanden werden, die sich zumindest in einer ihrer Schnittebenen in Richtung auf das Substrat hin verjüngt. Unterätzte Strukturen 6 können nicht nur durch einen Ätz-Prozess sondern auch zum Beispiel mit Hilfe eines Lösungsmittels erhalten werden.

Gemäß Fig. 2b werden anschließend an die gemeinsame Strukturierung der Halbleiterschicht 1, der Isolatorschicht 2 und der Gate-Elektroden-Schicht 3 die Source- und Drain-Elektroden-Schichten 13, 13' ausgebildet. Die Bildung der Source- und Drain-Elektroden-Schichten 13, 13' kann in Analogie zu dem vorstehend Beschriebenen durch direkte oder indirekte Schicht-erzeugenden Prozesse erfolgen. In einem direkten Prozess kann zum Beispiel ein justagetolerantes leitfähiges Material 8 aufgebracht bzw. aufgedruckt werden, das bis zum Substrat fließt, die Source- und Drain-Elektroden-Schichten 13, 13' bildet und Kontakt in den Kontaktbereichen 14 zu der strukturierten Halbleiterschicht 10' herstellt. In einem alternativen indirekten Prozess kann zum Beispiel eine strukturierte Schutzschicht, insbesondere eine Schutzlack-Schicht, aufgebracht werden, so dass anschließend auf die nicht durch die Schutzschicht bedecken Bereiche ein leitfähigges Material 8 zur Bildung der Source- und Drain-Elektroden-Schichten 13, 13' gezielt aufgebracht werden kann.

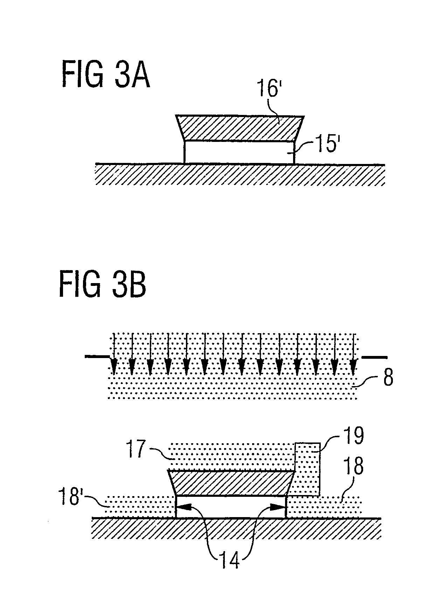

Eine weitere Ausführungsform zur Herstellung eines nicht erfindungsgemäßen organischen Transistors ist beispielhaft in den Fig. 3a und Fig. 3b illustriert. Diese weitere Ausführungsform entspricht im wesentlichen der vorstehend beschriebenen zweiten Ausführungsform.

Ausgangspunkt ist wie vorstehend in bezug auf Fig. 1a beschrieben, ein Substrat, auf dem eine unstrukturierte, homogene Halbleiterschicht 1 angeordnet ist, die von einer unstrukturierten Isolatorschicht 2 bedeckt ist. Im Gegensatz zu der vorstehenden Beschreibung ist die Isolatorschicht 2 jedoch nicht durch eine Gate-Elektroden-Schicht 3 bedeckt.

Die unstrukturierten von dem Substrat getragenen Halbleiterschicht 1 und Isolatorschicht 2 werden anschließend gemeinsam strukturiert. Die Strukturierung kann zum Beispiel mittels Abtragen durch einen Laser erfolgen oder alternativ mittels Schutzlack in lithographischen oder drucklithographischen Prozessen.

Fig. 3a zeigt die Ausbildung der funktionellen Schichten nach der vorstehend beschriebenen Strukturierung. Sowohl die Halbleiterschicht 15' als auch die Isolatorschicht 16' liegen strukturiert vor. Gemäß Fig. 3a kann die Isolatorschicht 16' ebenfalls unterätzte Strukturen aufweisen, die einen Kurzschluss zwischen einer zu erzeugenden Gate-Elektroden-Schicht und zu erzeugenden Source- bzw. Drain-Elektroden-Schichten verhindern können.

Gemäß Fig. 3b werden anschließend an die gemeinsame Strukturierung der Halbleiterschicht 1 und der Isolatorschicht 2 eine Gate-Elektroden-Schicht 17' und die Source- und Drain-Elektroden-Schichten 18, 18' ausgebildet. Die Bildung der Gate-Elektroden-Schicht 17 und der Source- und Drain-Elektroden-Schichten 18, 18' kann in Analogie zu dem vorstehend beschriebenen durch direkte oder indirekte Schicht-erzeugenden Prozesse erfolgen. In einem direkten Prozess kann zum Beispiel ein justagetolerantes leitfähiges Material 8 aufgebracht bzw. aufgedruckt werden, das einerseits bis zum Substrat fließt, um die Source- und Drain-Elektroden-Schichten 18, 18' zu bilden und Kontakt in den Kontaktbereichen 14 zu dem Halbleiter herstellt, und das andererseits auf der strukturierten Isolatorschicht 16 die Gate-Elektroden-Schicht 17 bildet. In einem alternativen indirekten Prozess kann zum Beispiel eine strukturierte Schutzschicht, insbesondere eine Schutzlack-Schicht, aufgebracht werden, so dass anschließend auf die nicht durch die Schutzschicht bedecken Bereiche ein leitfähiges Material 8 zur Bildung der Gate-Elektroden-Schicht 17 und der Source- und Drain-Elektroden-Schichten 18, 18' gezielt aufgebracht werden kann.

Vorteilhafterweise kann ebenfalls eine Kontaktstelle 19 zwischen Source- bzw. Drain-Elektroden-Schicht und Gate-Elektroden-Schicht hergestellt werden, indem an der gewünschten Kontaktstelle 19 mehr leitfähiges Material 8 aufgebracht wird, oder indem an der Kontaktstelle 19 ein zweites Mal leitfähiges Material 8 aufgebracht wird. Ein Transistor mit einem Kontakt zwischen Source- bzw. Drain-Elektroden-Schichten und Gate-Elektroden-Schicht kann als Diode eingesetzt werden.

Das vorstehend beschriebene Verfahren ist im Rahmen einer Stäbchengeometrie des herzustellenden organischen Transistors beschrieben, d.h. die Source- bzw. Drain-Elektroden-Schichten liegen sich auf der gesamten Kanallänge gegenüber. Alternativ kann das vorstehend beschriebene Verfahren ebenfalls zur Fertigung einer interdigitalen Fingerstruktur eingesetzt werden, bei der die einzelnen Kontaktfinger ineinander greifen. Entscheidend ist die Abdeckung der Kanalstruktur der Halbleiterschicht durch die Isolatorschicht, so dass ein Kurzschluss zwischen Source- bzw. Drain-Elektroden-Schichten und Gate-Elektroden-Schicht ausgeschlossen ist.

Es ist im Rahmen der vorstehenden Beschreibung ersichtlich, dass das in verschiedenen Ausführungsformen dargestellte Verfahren keine Justage hoher Genauigkeit bei den einzelnen Fertigungsschritten erfordert und dennoch die Fertigung eines organischen Transistors hoher Qualität ermöglicht.

Eine Überlappung der Gate-Elektroden-Schicht 3' und Source- und Drain-Elektroden-Schichten 4, 4', wie in Fig. 1c dargestellt und dargelegt, ist ausgeschlossen, da Source- und Drain-Elektroden-Schichten 4, 4' nur in Bereichen erzeugt werden, die nicht von der Gate-Elektroden-Schicht 3' bzw, der Isolatorschicht 2' bedeckt sind. Die Kontaktbereiche 5, welche die Kontaktbereiche des halbleitenden Halbleiterbereichs (d,h, Kanalbereich des Transistors) und der dotierten Halbleiter-Bereiche bezeichnen, die leitfähig sind, so dass diese Bereiche als Source- und Drain-Elektroden-Schichten 4, 4' dienen, sind entsprechend der gemeinsamen Strukturierung der Gate-Elektroden-Schicht 3' und Isolatorschicht 2' wohl definiert.

Selbiges gilt im Hinblick auf die Ausführungen gemäß Fig. 2b und Fig. 3b. Eine Überlappung der Gate-Elektroden-Schicht 12' und Source- bzw. Drain-Elektroden-Schichten 13, 13', wie in Fig. 2b dargestellt, und eine Überlappung der Gate-Elektroden-Schicht 17 und Source- bzw. Drain-Elektroden-Schichten 18, 18', wie in Fig. 3b dargestellt, ist ebenfalls verfahrensbedingt ausgeschlossen. Die Kontaktbereiche 14 zwischen Halbleiter 10' bzw. 15' und Source- und Drain-Elektroden-Schichten 13, 13' bzw. 18, 18' sind ebenso entsprechend der gemeinsamen Strukturierung der Gate-Elektroden-Schicht, der Isolatorschicht und Halbleiterschicht bzw. der Isolatorschicht und Halbleiterschicht wohl definiert.

## Patentansprüche

1. Verfahren zum Herstellen eines organischen Transistors, **dadurch gekennzeichnet, dass** ein Substrat mit zumindest einer Halbleiterschicht (1), einer Isolatorschicht (2) und einer Gate-Elektrodenschicht (3) bereitgestellt wird, die aufeinander in der genannten Reihenfolge unstrukturiert angeordnet sind;
wobei das Verfahren umfasst:
- Gleichzeitiges Strukturieren der Halbleiterschicht (1), der Isolatorschicht (2) und der Grate-Elektrodenschicht (3), so dass Bereiche des Substrats freiliegen und
- Bilden der Source- und Drain-Elektroden-Schichten (18, 18') durch Aufbringen einer leitfähigen Substanz (8) auf die freiliegenden Bereiche des Substrats.

2. Verfahren nach Anspruch 1, **dadurch gekennzeichnet, dass** die Source- und Drain-Elektroden-Schichten (4, 4', 13, 13'; 18, 18') so gebildet sind, dass sie die Gate-Elektroden-Schicht (3'; 12'; 17) nicht überlappen.

3. Verfahren nach einem der vorstehenden Ansprüche, **dadurch gekennzeichnet, dass** die Strukturierung mittels eines Lasers, eines lithographischen Prozesses oder eines drucklithographischen Prozesses durchgeführt werden kann.

4. Verfahren nach einem der vorstehenden Ansprüche, **dadurch gekennzeichnet, dass** das Substrat eine Kunststofffolie, insbesondere eine Polyesterfolie ist.

5. Verfahren nach einem der vorstehenden Ansprüche, **dadurch gekennzeichnet, dass** die Halbleiterschicht (1, 1'; 10'; 15') aus einer organischen halbleitenden Substanz gebildet ist.

6. Verfahren nach einem der vorstehenden Ansprüche, **dadurch gekennzeichnet, dass** die Isolatorschicht (2, 2'; 11'; 16') aus einer organischen elektrisch isolierenden Substanz gebildet ist.

## Claims

1. Method for the production of an organic transistor, **characterized in that** provision is made of a substrate with at least one semiconductor layer (1), an insulator layer (2) and a gate electrode layer (3), which are arranged unpatterned on one another in the stated order;
the method comprising:
- simultaneous patterning of the semiconductor layer (1), of the insulator layer (2) and of the gate electrode layer (3) so that regions of the substrate are uncovered and
- formation of the source and drain electrode layers (18, 18') by application of a conductive substance (8) to the uncovered regions of the substrate.

2. Method according to claim 1, **characterized in that** the source and drain electrode layers (4, 4', 13, 13'; 18, 18') are formed such that they do not overlap the gate electrode layer (3'; 12'; 17).

3. Method according to one of the preceding claims, **characterized in that** the patterning can be carried out by means of a laser, a lithographic process or a printing lithographic process.

4. Method according to one of the preceding claims, **characterized in that** the substrate is a plastic film, in particular a polyester film.

5. Method according to one of the preceding claims, **characterized in that** the semiconductor layer (1, 1'; 10'; 15') is formed from an organic semiconducting substance.

6. Method according to one of the preceding claims, **characterized in that** the insulator layer (2, 2'; 11'; 16') is formed from an organic electrically insulating substance.

## Revendications

1. Procédé de fabrication d'un transistor organique, **caractérisé en ce qu'**un substrat doté au moins d'une couche semi-conductrice (1), d'une couche isolante (2) et d'une couche électrode grille (3), lesquelles sont agencées de façon non structurée les unes sur les autres dans l'ordre indiqué, est mis à disposition,
le procédé comprenant les étapes consistant à :
- structurer simultanément la couche semi-conductrice (1), la couche isolante (2) et la couche électrode grille (3), de sorte que les zones du substrat sont découvertes et
- former les couches d'électrodes source et drain (18, 18') en amenant une substance conductrice (8) sur les zones découvertes du substrat.

2. Procédé selon la revendication 1, **caractérisé en ce que** les couches d'électrodes source et drain (4, 4', 13, 13', 18, 18') sont formées, de sorte qu'elles ne chevauchent pas la couche électrode grille (3' ; 12' ; 17).

3. Procédé selon l'une quelconque des revendications précédentes, **caractérisé en ce que** la structuration peut être effectuée au laser, au moyen d'un procédé lithographique ou au moyen d'un procédé de lithographie sous pression.

4. Procédé selon l'une quelconque des revendications précédentes, **caractérisé en ce que** le substrat est une feuille de plastique, plus particulièrement une feuille de polyester.

5. Procédé selon l'une quelconque des revendications précédentes, **caractérisé en ce que** la couche semi-conductrice (1, 1' ; 10' ; 15') est formée à partir d'une substance organique semi-conductrice.

6. Procédé selon l'une quelconque des revendications précédentes, **caractérisé en ce que** la couche isolante (2, 2' ; 11' ; 16') est formée à partir d'une substance organique isolante électriquement.
